# EUROPÄISCHE PATENTSCHRIFT

(11) **EP 1 095 169 B1**
(45) Veröffentlichungstag und Bekanntmachung des Hinweises auf die Patenterteilung: **02.05.2002**
(21) Anmeldenummer: 99939326.7
(22) Anmeldetag: 15.06.1999
(51) Int. Cl.: C23C 4/12, C23C 16/44

(54) **VERFAHREN UND VORRICHTUNG ZUM ERZEUGEN EINES PULVERAEROSOLS SOWIE DEREN VERWENDUNG**
METHOD AND DEVICE FOR PRODUCING A POWDER AEROSOL AND USE THEREOF
PROCEDE ET DISPOSITIF POUR LA PRODUCTION D'UN AEROSOL PULVERULENT, AINSI QUE SON UTILISATION

(30) Priorität: 15.06.1998 DE 19826550
(43) Veröffentlichungstag der Anmeldung: 02.05.2001
(73) Patentinhaber: SIEMENS AKTIENGESELLSCHAFT, 80333 München (DE)
(72) Erfinder: BRANSTON, David-Walter, D-91090 Effeltrich (DE); LINS, Günter, D-91056 Erlangen (DE); VERLEGER, Jobst, D-91052 Erlangen (DE)
(86) Internationale Anmeldenummer: DE9901745
(87) Internationale Veröffentlichungsnummer: WO9966096

(56) Entgegenhaltungen:
- EP-A- 0 411 499
- EP-A- 0 441 300
- WO-A-95/03872
- WO-A-96/03216
- DE-A- 3 417 439
- DE-A- 3 729 391
- DE-A- 3 937 983
- PATENT ABSTRACTS OF JAPAN vol. 1996, no. 10, 31. Oktober 1996 (1996-10-31) & JP 08 158033 A (NISSHIN STEEL CO LTD), 18. Juni 1996 (1996-06-18)

## Beschreibung

Die Erfindung bezieht sich auf ein Verfahren zum Erzeugen eines Pulveraerosols, das dosiert über einen Gasstrom einem Plasmabrenner zugefübrbar ist, wozu ein desagglomeriertes Pulveraerosol als stetiger Massenstrom notwendig ist, sowie dessen Verwendung. Daneben bezieht sich die Erfindung auch auf eine Vorrichtung zum Erzeugen eines Pulveraerosols mit einem Behälter, der über eine Sonotrode mit einem Ultraschallgeber verbunden ist und das ein Zuleitungsrohr und ein Ausleitungsrohr aufweist.

Eine hochfrequenzangeregter Plasmabrenner hoher Leistung kann dazu eingesetzt werden, pulverförmige Substanzen in kurzer Zeit vollständig zu verdampfen und nachfolgend aus der Dampfphase eine Schicht vorgegebener Zusammensetzung mit hoher Aufwachsrate auf einem Substrat abzuscheiden. Eine erste Anwendung für dieses als Plasmastrahlverdampfung ("Plasma Flash Evaporation") bekannte Verfahren ist das Verdampfen eines feinkörnigen Pulvers aus Yttrium-Barium-Kupfer-Oxid mit anschließender Deposition einer HTSL(hochtemperatursupraleitenden)-Schicht. Eine andere wesentliche Anwendung ist das Beschichten von Bauteilen, beispielsweise das Aufbringen einer Schutzschicht auf eine Turbinenschaufel.

Um das Pulver in das Plasma zu transportieren, bringt man es in ein Trägergas ein, so daß ein Aerosol entsteht, das in den Plasmabrenner geleitet werden kann. Das Aerosol muß frei von nicht verdampfbaren Zusammenballungen von Pulverpartikeln, d.h. aus einzelnen Partikeln gebildeten Agglomeraten, sein, und die Förderung soll reproduzierbar und gleichmäßig, d.h. frei von zeitlichen Schwankungen, erfolgen.

Zur Erzeugung des für die Plasmastrahlverdampfung benötigten *Aerosols* sind unterschiedliche Verfahren, die aus der allgemeinen Plasmaspritztechnik stammen, bekannt. Beispielsweise arbeitet ein Scheibenförderer in der Weise, daß durch eine Dosiernut auf einer langsam rotierenden Scheibe eine durch die Abmessungen der Nut definierte Pulvermenge kontinuierlich abgelegt wird. Das mit der Scheibe umlaufende Pulver wird durch eine Abstreifvorrichtung an den Rand der Scheibe geführt und fällt in eine Aufnahmevorrichtung, wo es von einem Gasstrom aufgenommen wird. Bei sehr feinkörnigen Pulvern mit Korngrößen z.B. im Bereich kleiner oder gleich 20 µm ist die Rieselfähigkeit durch die zwischen den Partikeln wirkenden Kräfte stark eingeschränkt. Dies führt dazu, daß nicht, wie erforderlich, kontinuierlich einzelne, voneinander getrennte Pulverkörner, sondern Zusammenballungen mit Abmessungen im Millimeterbereich in gewissen zeitlichen Abständen in den Gasstrom gelangen. Auch wenn sich in günstigen Fällen die Agglomerate während des Transportes zum Plasmabrenner auflösen, resultieren aus der klumpigen Struktur des eingebrachten Pulvers nicht mehr tolerierbare zeitliche Schwankungen, d.h. eine Pulsation der ins Plasma eingebrachten Pulvermenge. Denselben Nachteil weisen die ebenfalls dem Stand der Technik entsprechenden Schrauben- oder Schneckenförderer auf, bei denen das Pulver durch eine Schnecke einem Mischraum zugeführt wird, wo es in den Trägergasstrom gelangt.

Bei einem Bürstendosierer wird das zu einem zylindrischen Körper gestopfte Pulver durch ein Rohr zu einer rotierenden Metallbürste vorgeschoben, die eine der Vorschubgeschwindigkeit proportionale Menge des Pulvers vom Stopfkörper abträgt. Ein den Bürstenraum durchsetzender Gasstrom nimmt das Pulver auf und transportiert es an den Ort, an dem es benötigt wird. Die Erfahrung zeigt, daß bereits beim Abreiben des Pulvers vom Stopfkörper nicht verdampfbare Agglomerate entstehen.

Aus der WO 96/03216 A1 ist ein Pulverförderer bekannt, der nach einem Ultraschallprinzip arbeitet. Hierbei wird das zu fördernde Pulver in einem Gefäß, in dem es auch bereitgehalten wird, mit Ultraschall beaufschlagt, aufgewirbelt, desagglomeriert und von einem das Gefäß durchsetzenden Gasstrom aufgenommen. Experimente haben gezeigt, daß die Förderung reproduzierbar und schwankungsfrei erfolgt. Die Grenzen dieses Verfahrens liegen darin, daß nur eine begrenzte Pulvermenge bereitgehalten und gefördert wird. Insbesondere die Förderrate, d.h. die pro Zeiteinheit geförderte Masse, kann dabei nicht unabhängig von der Gasdurchflußrate eingestellt werden, da neben der Ultraschalleinwirkung auch der Gasstrom zur Aufwirbelung des Pulvers beiträgt.

Davon ausgehend ist es Aufgabe der Erfindung, die Bereitstellung des Aerosols zu verbessern und eine zugehörige Vorrichtung zu schaffen sowie eine geeignete Anwendung anzugeben.

Die Aufgabe wird bei einem Verfahren der eingangs genannten Art erfindungsgemäß mit den Verfahrensschritten gemäß Patentanspruch 1 gelöst. Eine zugehörige Vorrichtung ist in Patentanspruch 2 sowie eine geeignete Verwendung des Verfahrens bzw. der zugehörigen Vorrichtungen ist in Anspruch 8 angegeben. Bevorzugte Ausführungsformen des vorrichtung bzw. der verwendung sind in den Ansprüchen 3 bis 7 bzw. 9 und 10 definiert.

Bei der Erfindung werden mechanische Mittel zur Überführung des Pulvers in das Aerosol verwendet. Im Rahmen der Erfindung wird der Gasstrom mit dem Pulveraerosol einem Plasmabrenner zugeführt. Dabei dient vorteilhafterweise das mit Ultraschall beaufschlagbare Volumen als Speicher- und/oder Puffermittel für das Pulveraerosol.

Mit der Erfindung ist erreicht, daß nunmehr das Pulveraerosol in gleichmäßiger, feiner Partikelverteilung im Gasstrom vorliegt. Dabei wird gleichermaßen das so behandelte Pulveraerosol desagglomeriert und der zunächst fluktuierende Massenstrom verstetigt.

Bei der zugehörigen Vorrichtung der eingangs genannten Art ist erfindungsgemäß das Zuleitungsrohr mit einem mechanischen Pulverförderer verbunden. Dadurch gelangt in das durch das Ultraschallgefäß gebildete Volumen bereits ein Pulveraerosol, das durch die Ultraschalleinwirkung vergleichmäßigt wird und das als gleichmäßiger und stetiger Aerosolstrom das Ultraschallgefäß verläßt und zu einem Plasmabrenner geführt wird. Dabei ist das Gefäß vorzugsweise nach oben durch einen Deckel abgeschlossen. Insbesondere kann das Gefäß gleichzeitig die Sonotrode beinhalten.

Durch die Erfindung kann also ein Feinstpulver in beliebiger Menge kontinuierlich, agglomerationsfrei, reproduzierbar und ohne zeitliche Schwankungen in ein Plasma eingebracht werden. Letzteres geschieht durch die Kombination eines Scheiben-, Schnecken- oder Bürstenförderers mit dem der WO 96/03216 A1 zugrundeliegenden Ultraschallprinzip.

Die Erfindung findet Anwendung beim Beschichten von Bauteilen und ist insbesondere zum Aufbringen einer Schutzschicht auf Turbinenschaufeln geeignet. Dabei ist besonderes vorteilhaft, daß durch die leicht mögliche Relativbewegung zwischen der erfindungsgemäßen Vorrichtung und der Turbinenschaufel in vertretbaren Zeiten geeignete Schichtdicken abgeschieden werden können.

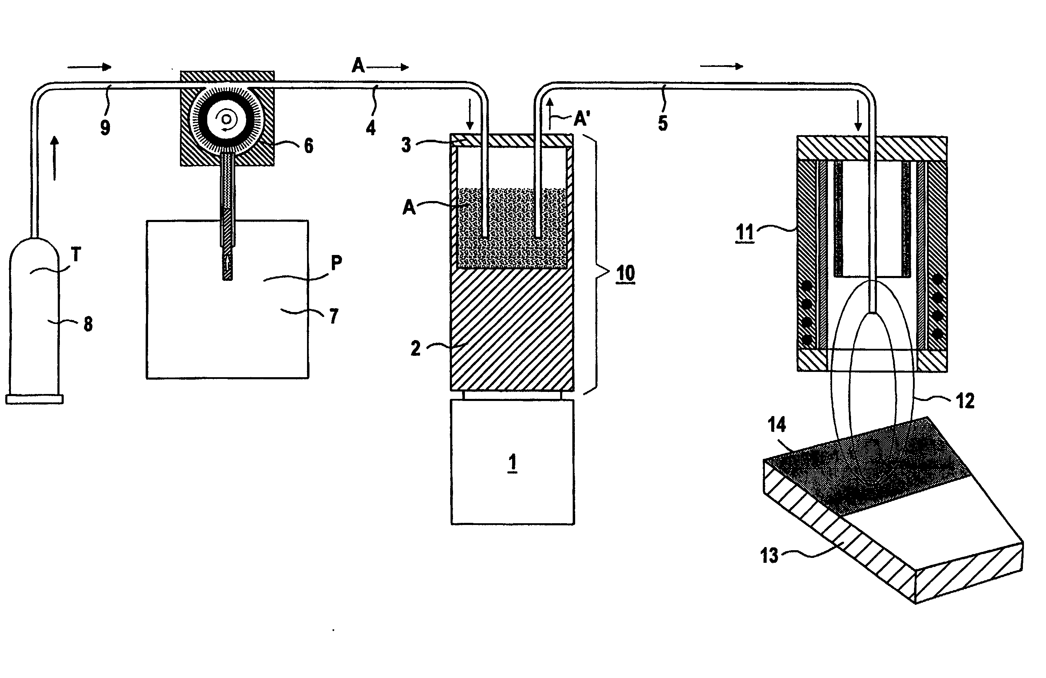

Weitere Ausgestaltungen und Vorteile der Erfindung ergeben sich aus der nachfolgenden Figurenbeschreibung eines Ausführungsbeispiels anhand der einzigen Figur der Zeichnung in Verbindung mit den Patentansprüchen.

Die Figur zeigt ein Ausführungsbeispiel eines erfindungsgemäßen Pulverfördersystems, das zum Betrieb eines Plasmabrenners vorgesehen ist. Als Plasmabrenner dient ein hochfrequenzangeregter Induktions-Plasmagenerator 11, der aus einem Brenngas ein induktiv gekoppeltes Plasma mit einer gerichteten Plasmaflamme 12 bildet. In die Plasmaflamme 12 wird ein Aerosol eingebracht, das aufgrund der hohen Plasmatemperaturen vollständig verdampft wird. Dies ermöglicht, Materialien aus der Dampfphase auf Bauteiloberflächen mit hoher Aufwachsrate abzuscheiden.

Letzteres soll zum Aufbringen von Schutzschichten auf Turbinenschaufeln ausgenutzt werden. Ein Teil einer gekrümmten Turbinenschaufel 13 ist in der Figur einschließlich Beschichtung 14 angedeutet. Solche Turbinenschaufeln sind im Betrieb hohen Beanspruchungen bei wechselnden Temperaturen ausgesetzt, weshalb die aus Speziallegierungen bestehenden Schaufeln beschichtet werden. Beispielsweise kommen Schichten aus Keramik, insbesondere Zirkonoxid (ZrO₂), aber auch andere oxidische oder nitridische Materialien, in Frage. Bei Induktions-Plasmabrennern können auch ohne großen Aufwand die Beschichtungsmaterilen ausgetauscht werden, so daß leicht Mehrschicht-Systeme herstellbar sind

Eine mit einem Ultraschallgenerator 1 für Generierung von Ultraschall vorgegebener Frequenz verbundene Sonotrode 2 zur Übertragung des Ultraschalls mit geeigneter Wellenlänge ist teilweise als Hohlkörper ausgebildet und bildet einen Behälter, der mit Ultraschall beaufschlagt werden kann. Es wird so eine "Bechersonotrode", die mit einem Deckel 3 abgeschlossen wird, als Ultraschallgefäß 10 definiert. Der Deckel 3 wird von einem Zuleitungsrohr 4 und einem Ausleitungsrohr 5 durchsetzt, wobei Zuleitungsrohr 4 und Ausleitungsrohr 5 zueinandersymmetrisch angeordnet sind.

In alternativer Ausbildung kann eine separate Sonotrode 2 mit einem separaten Gefäß ultraschallmäßig verbunden sein.

Mit einem Pulverförderer 6, der ein mechanischer Scheiben-, Schnecken-, Bürsten- oder ein sonstiger, für die Dosierung von Feinstpulvern geeigneter Förderer sein kann und der in der Figur nur angedeutet ist, wird ein in einem Behälter 7 bevorratetes Pulver P in einen Gasstrom eines Trägergases T überführt und so ein Pulveraerosol A erzeugt.

Der Pulverförderer 6 ist mit der Bechersonotrode 2 in der Weise verbunden, daß das von ihm erzeugte Pulveraerosol A durch das Zuleitungsrohr 4 in deren Innenraum geleitet wird und darin im Gasstrom schwebt. Ohne Ultraschallbeaufschlagung würden sich schwerere Teilchen, wie Pulverklumpen und Agglomerate, dabei am Boden des Gefäßes 10 ablagern.

Die Ultraschalleinwirkung führt zur Auflösung von Pulverklumpen und Agglomeraten, was bisher zu Problemen führte. Nunmehr verläßt ein mit einer gewünschten gleichmäßigen feinen Partikelverteilung aufbereitetes Pulveraerosol A' durch das Ausleitungsrohr 5 die Bechersonotrode 2 und kann im Gasstrom dem Plasmabrenner 11 zugeführt werden.

Aus der spezifischen Kombination des Pulverförderers 6 mit der im einzelnen beschriebenen Ultraschalleinrichtung resultiert in vorteilhafter Weise der unerwartete Effekt einer Vergleichmäßigung des Pulverstromes. Die Vergleichmäßigung des Pulverstromes kann durch die Speicher- und/oder Pufferwirkung des mit Ultraschall beaufschlagten Volumens mit dem Pulveraerosol A berklärt werden. Damit erhalten die mit dem Plasmabrenner 11 auf einem Substrat, insbesondere einer Turbinenschaufel 13, erzeugte Schicht 14 eine besonders hohe Qualität.

## Patentansprüche

1. Verfahren zum Erzeugen eines Pulveraerosols, das dosiert über einen Gasstrom einem Plasmabrenner zugeführbar ist, wozu ein desagglomeriertes Pulveraerosol als stetiger Massenstrom notwendig ist, mit folgenden Verfahrensschritten:
- Pulver wird mit mechanischen Mitteln aus einem Vorratsraum entnommen und über ein Trägergas in ein Pulveraerosol überführt,
- das Pulveraerosol wird in einen mit Ultraschall beaufschlagbaren Behälter eingebracht, dessen mit Ultraschall beaufschlagtes Volumen als Speicher- und/oder Puffermittel für das Aerosol dient,
- durch die Ultraschalleinwirkung werden Pulverklumpen und Agglomerate im Pulveraerosol aufgelöst und somit das Pulveraerosol vergleichmäßigt und verfeinert,
- das vergleichmäßigte und verfeinerte Pulveraerosol wird dem Plasmabrenner zugeführt.

2. Vorrichtung zum Erzeugen eines Pulveraerosols (A), mit einem Behälter (10), der über eine Sonotrode (2) mit einem Ultraschallgeber (1) verbunden ist und der ein Zuleitungsrohr (4) und ein Ausleitungsrohr (5) aufweist, wobei das Zuleitungsrohr (4) mit einem Pulverförderer (6), der Anschlüsse für einem Vorratsbehälter (7) für ein Pulver (P) und für ein Trägergas (T) enthält, verbunden ist und wobei das Ausleitungsrohr (5) mit einem Plasmabrenner (11) verbunden ist.

3. Vorrichtung nach Anspruch 2, **dadurch gekennzeichnet, daß** die Sonotrode (2) becherförmig ausgebildet ist.

4. Vorrichtung nach Anspruch 3, **dadurch gekennzeichnet, daß** die becherförmige Sonotrode (2) den Behälter (10) bildet.

5. Vorrichtung nach einem der Ansprüche 2, 3 oder 4, **dadurch gekennzeichnet, daß** der Behälter (10) nach oben durch einen Deckel (3) abgeschlossen ist.

6. Vorrichtung nach einem der Ansprüche 2 bis 5, **dadurch gekennzeichnet, daß** das Zuleitungsrohr (4) und das Ausleitungsrohr (5) in bezug auf die Sonotrode (2) oder den mit Ultraschall beaufschlagten Behälter (10) symmetrisch angeordnet sind.

7. Vorrichtung nach Anspruch 3, **dadurch gekennzeichnet, daß** der Plasmabrenner einen Induktions-Plasmagenerator (11) enthält.

8. Verwendung des Verfahrens gemäß Anspruch 1 und/oder der Vorrichtung gemäß einem der Ansprüche 2 bis 7 zum Aufbringen einer Schutzschicht (14) auf eine Turbinenschaufel (13).

9. Verwendung nach Anspruch 8, **dadurch gekennzeichnet, daß** die Schutzschicht (14) eine keramische Schicht (14) ist.

10. Verwendung nach Anspruch 8 oder Anspruch 9 , **dadurch gekennzeichnet , daß** die Schicht (14) Zirkonoxid (ZrO₂) umfaßt.

## Claims

1. Method for producing a powdered aerosol which can be supplied in metered form via a gas flow to a plasma burner, for which purpose a deagglomerated powder aerosol is required as a continuous mass flow, comprising the following method steps:
- powder is removed from a reservoir area using mechanical means, and is changed to a powder aerosol by using a carrier gas,
- the powder aerosol is introduced into a container to which ultrasound can be applied and whose volume to which ultrasound is applied is used as a storage and/or buffer means for the aerosol,
- the influence of the ultrasound is used to break up powder lumps and agglomerates in the powder aerosol, and thus to make the powder aerosol more uniform and refined, and
- the powder aerosol which has been made more uniform and refined is supplied to the plasma burner.

2. Apparatus for producing a powder aerosol (A), having a container (10) which is connected via an ultrasound horn (2) to an ultrasound transmitter (1) and which has an inlet supply pipe (4) and an outlet supply pipe (5), with the inlet supply pipe (4) being connected to a powder feeder (6) which contains connections for a reservoir container (7) for a powder (P) and for a carrier gas (T), and with the outlet supply pipe (5) being connected to a plasma burner (11).

3. Apparatus according to Claim 2, **characterized in that** the ultrasound horn (2) is in the form of a cup.

4. Apparatus according to Claim 3, **characterized in that** the ultrasound horn (2), which is in the form of a cup, forms the container (10).

5. Apparatus according to one of Claims 2, 3 or 4, **characterized in that** the container (10) is closed at the top by a cover (3).

6. Apparatus according to one of Claims 2 to 5, **characterized in that** the inlet supply pipe (4) and the outlet supply pipe (5) are arranged symmetrically with respect to the ultrasound horn (2) or with respect to the container (10) to which ultrasound is applied.

7. Apparatus according to Claim 3, **characterized in that** the plasma burner contains an induction plasma generator (11).

8. Use of the method according to Claim 1 and/or the apparatus according to one of Claims 2 to 7 for applying a protective layer (14) to a turbine blade (13).

9. Use according to Claim 8, **characterized in that** the protective layer (14) is a ceramic layer (14).

10. Use according to Claim 8 or Claim 9, **characterized in that** the layer (14) is composed of zirconium oxide (ZrO₂).

## Revendications

1. Procédé de production d'un aérosol pulvérulent qui peut être apporté de manière dosée par un courant gazeux à un chalumeau à plasma en utilisant comme courant massique permanent un aérosol pulvérulent désaggloméré, comprenant les stades de procédé suivants :
- on prélève de la poudre par des moyens mécaniques d'une chambre formant réservoir et on la transforme par un gaz porteur en un aérosol pulvérulent,
- on introduit l'aérosol pulvérulent dans une cuve pouvant être soumise à des ultrasons et dont le volume qui peut être soumis à des ultrasons sert de moyen de stockage et/ou de moyen tampon pour l'aérosol,
- on désagrège par l'action des ultrasons des mottes de poudres et des conglomérats dans l'aérosol pulvérulent et on rend ainsi uniforme et plus fin l'aérosol pulvérulent,
- on envoie l'aérosol rendu plus uniforme et plus fin au chalumeau à plasma.

2. Dispositif de production d'un aérosol (A) pulvérulent comprenant une cuve (10) qui communique par une sonotrode (2) avec un générateur (1) d'ultrasons et qui comporte un tuyau (4) d'entrée et un tuyau (5) de sortie, le tuyau (4) d'entrée communiquant avec un convoyeur (6) de poudre qui comprend des raccords pour un réservoir (7) d'une poudre (P) et d'un gaz (T) porteur et le tuyau (5) de sortie communiquant avec un chalumeau (11) à plasma.

3. Dispositif suivant la revendication 2, **caractérisé en ce que** la sonotrode (2) est constituée sous la forme d'une coupe.

4. Dispositif suivant la revendication 3, **caractérisé en ce que** la sonotrode (2) en forme de coupe forme la cuve (10).

5. Dispositif suivant l'une des revendications 2, 3 ou 4, **caractérisé en ce que** la cuve (10) est fermée vers le haut par un couvercle (3).

6. Dispositif suivant l'une des revendications 2 à 5, **caractérisé en ce que** le tuyau (4) d'entrée et le tuyau (5) de sortie sont disposés symétriquement par rapport la sonotrode (2) ou par rapport à la cuve (10) qui est soumise aux ultrasons.

7. Dispositif suivant la revendication 3, **caractérisé en ce que** le chalumeau à plasma comporte un générateur (11) de plasma à induction.

8. Utilisation du procédé suivant la revendication 1 et/ou du dispositif suivant l'une des revendications 2 à 7 pour déposer une couche (14) de protection sur une aube (13) de turbine.

9. Utilisation suivant la revendication 8, **caractérisée en ce que** la couche (14) de protection est une couche (14) en céramique.

10. Utilisation suivant la revendication 8 ou suivant la revendication 9, **caractérisée en ce que** la couche (14) comprend de l'oxyde de zirconium (ZrO₂).
